# EUROPEAN PATENT SPECIFICATION

(11) **EP 3 343 764 B1**
(45) Date of publication and mention of the grant of the patent: **11.02.2026**
(21) Application number: 17210686.6
(22) Date of filing: 27.12.2017
(51) Int. Cl.: H03F 3/30, H03F 1/32

(54) **FLOATING POWER SOURCE CIRCUIT AND AMPLIFIER**
SCHWEBENDE STROMQUELLENSCHALTUNG UND VERSTÄRKER
CIRCUIT DE SOURCE D'ALIMENTATION FLOTTANTE ET AMPLIFICATEUR

(30) Priority: 27.12.2016 JP 2016252274
(43) Date of publication of application: 04.07.2018
(73) Proprietor: YAMAHA CORPORATION, 430-8650 Shizuoka Hamamatsu-shi (JP)
(72) Inventor: Fujita, Shinichi, Shizuoka, 430-8650 (JP)
(74) Representative: Hoffmann Eitle

(56) References cited:
- JP-B2- 3 139 386
- US-A- 5 250 911
- BOB CORDELL: "Designing Audio Power Amplifiers", 2011, MCGRAW-HILL, ISBN: 978-0-07-164025-1, article "Section 7.4 Unipolar Input Stage and Push-Pull VAS", pages: 142 - 146, XP002780914

## Description

### BACKGROUND OF THE INVENTION

### 1. Field of the Invention

The present invention relates to a floating power source circuit and to an amplifier provided with the floating power source circuit.

### 2. Description of the Prior Art

In an audio circuit such as an amplifier, a floating power source is sometimes used as a power source for driving transistors. For example, JP-B-3139386 discloses an amplifier which uses two floating power sources to push-pull drive two transistors connected to positive and negative phase output terminals.

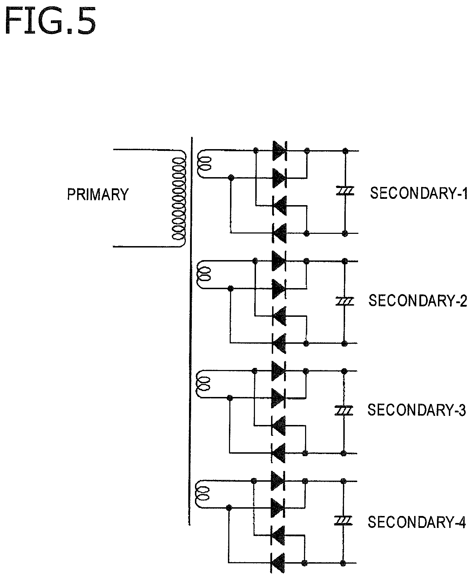

In the prior art, such a floating power source has a transformer exemplified in Fig. 5. In the example shown in Fig. 5, four secondary windings are disposed in the transformer, full-wave rectifier circuits each having four diodes are connected to the secondary windings, respectively, and smoothing circuits each having a capacitor are connected to the full-wave rectifier circuits, respectively. The DC output voltages of the four smoothing circuits are supplied to various portions (not shown) of an amplifier which require a floating power source.

In the case where floating power sources are to be configured by using a transformer as described above, the secondary windings of the transformer, and rectifier/smoothing circuits are necessary in the number which is equal to the required number of the floating power sources, and there arises a problem in that the production cost of an amplifier is increased. Moreover, the number of lead wires of the secondary windings disposed in the transformer is limited. When a large number of floating power sources are required, therefore, a plurality of transformers must be disposed. In the case of a small-power amplifier, a transformer must be disposed for only the purpose of providing floating power sources. This causes another problem in that the production cost is needlessly increased.
Document "Section 7.4 Unipolar Input Stage and Push-Pull VAS" In: Bob Cordell: "Designing Audio Power Amplifiers", 2011, McGraw-Hill, XP002780914, ISBN: 978-0-07-164025-1, pages 142-146, discusses solving the problem of designing audio power amplifiers using various circuits comprising a Vbe multiplier biasing an output stage.
Patent document JP 3 139386 B2 relates to an improved push-pull amplifier circuit which can obtain an output without waveform distortion by a fully symmetrical push-pull operation.

### SUMMARY OF THE INVENTION

The invention is solely defined by the appended claims. Embodiments not fully falling under the scope of the appended claims are to be merely considered as examples useful for understanding the invention.

The invention has been conducted in view of the above circumstances. It is an object of the invention to provide a floating power source circuit which can be configured without using an insulating unit such as a transformer.
An aspect provides a floating power source circuit characterized in that the floating power source circuit includes a constant-voltage source, and first and second constant-current sources which are connected in series. The constant-voltage source is arranged between the first and second constant-current sources.

According to an aspect, the first and second constant-current sources have a high internal impedance, and therefore the constant-voltage source functions as a floating constant-voltage source. According to an aspect of the invention, therefore, a floating power source can be configured without disposing an insulating unit such as a transformer.

### BRIEF DESCRIPTION OF THE DRAWINGS

Fig. 1 is a circuit diagram illustrating a configuration of a floating power source circuit according to a reference example of the invention.
Fig. 2 is a circuit diagram illustrating the configuration of an amplifier according to a first embodiment of the invention.
Fig. 3 is a view illustrating an operation range of a floating power source in the first embodiment.
Fig. 4 is a circuit diagram illustrating a configuration of a power source circuit according to a modification of the reference example.
Fig. 5 is a circuit diagram illustrating a configuration example of a floating power source provided with a transformer.

### DETAILED DESCRIPTION OF THE EXEMPLARY EMBODIMENTS

Hereinafter, embodiments of the invention will be described with reference to the drawings.

### <Reference example>

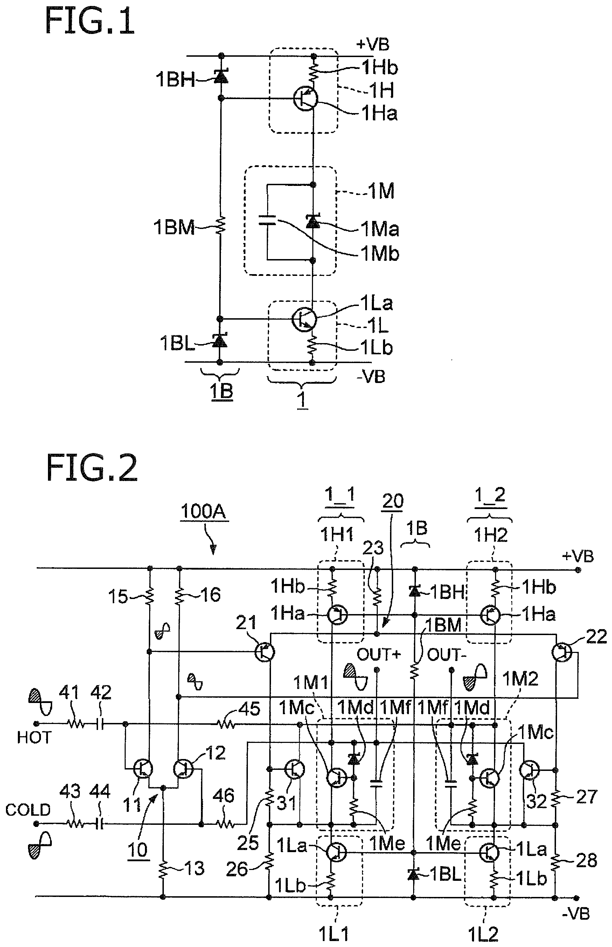

Fig. 1 is a circuit diagram illustrating a configuration of a floating power source circuit 1 according to a reference example of the invention. In Fig. 1, a bias circuit 1B is shown together with the floating power source circuit 1 in order to facilitate understanding of the configuration of the floating power source circuit 1.

As illustrated in Fig. 1, the floating power source circuit 1 includes a constant-voltage source 1M, and high- and low-side constant-current sources 1H, 1L which are connected in series between a high potential source +VB and a low potential source -VB through the constant-voltage source 1M. The bias circuit 1B includes a Zener diode 1BH, resistor 1BM, and Zener diode 1BL which are connected in series between the high potential source +VB and the low potential source -VB.

The high-side constant-current source 1H includes a PNP transistor 1Ha and a resistor 1Hb. Here, one end of the resistor 1Hb is connected together with the cathode of the Zener diode 1BH to the high potential source +VB, and the other end is connected to the emitter of the PNP transistor 1Ha. The anode of the Zener diode 1BH is connected to the base of the PNP transistor 1Ha. The high-side constant-current source 1H functions as a constant-current source with a current value which is obtained by dividing a voltage that is acquired by subtracting the base-emitter forward voltage of the PNP transistor 1Ha from the Zener voltage of the Zener diode 1BH, by the resistance of the resistor 1Hb.

The low-side constant-current source 1L includes an NPN transistor 1La and a resistor 1Lb. Here, one end of the resistor 1Lb is connected together with the anode of the Zener diode 1BL to the low potential source -VB, and the other end is connected to the emitter of the NPN transistor 1La. The cathode of the Zener diode 1BL is connected to the base of the NPN transistor 1La. The low-side constant-current source 1L functions as a constant-current source with a current value which is obtained by dividing a voltage that is acquired by subtracting the base-emitter forward voltage of the NPN transistor 1La from the Zener voltage of the Zener diode 1BL, by the resistance of the resistor 1Lb.

In the example, the Zener voltages of the Zener diodes 1BH, 1BL of the bias circuit 1B, and the resistances of the resistors 1Hb, 1Lb of the constant-current sources are determined so that the current values of the high- and low-side constant-current sources 1H, 1L are equal to each other.

The constant-voltage source 1M includes a Zener diode 1Ma and a capacitor 1Mb which is connected in parallel thereto. The cathode of the Zener diode 1Ma is connected to the collector of the PNP transistor 1Ha, and the anode is connected to the collector of the NPN transistor 1La. The Zener diode 1Ma functions as a constant voltage generating unit. The capacitor 1Mb functions as a smoothing circuit.

In the above-described configuration, the high- and low-side constant-current sources 1H, 1L which perform a constant-current operation have a high internal impedance, and therefore the constant-voltage source 1M functions as a floating constant-voltage source in an operation range where both the high- and low-side constant-current sources 1H, 1L function as a constant-current source. Therefore, a voltage can be taken out from the both ends of the constant-voltage source 1M, and the constant-voltage source 1M can be used as a floating constant-voltage source. In this case, the potentials of the both ends (the cathode and anode of the Zener diode 1Ma) of the constant-voltage source 1M are determined by the operation of a circuit (for example, a circuit including a load) which is connected to the both ends of the constant-voltage source 1M. According to the example, as described above, a floating power source can be configured without using an insulating unit such as a transformer.

### <First embodiment>

Fig. 2 is a circuit diagram illustrating the configuration of an amplifier 100A which is a first embodiment of the invention. In the embodiment, the floating power source circuit 1 of the above-described reference example is applied to the amplifier disclosed in JP-B-3139386.

As illustrated in Fig. 2, the amplifier 100A has a first stage differential amplifier section 10, a second stage differential amplifier section 20, a first output stage NPN transistor 31, a second output stage NPN transistor 32, resistors 45, 46 constituting a feedback circuit, a bias circuit 1B, and floating power source circuits 1_1, 1_2.

The bias circuit 1B is configured in the same manner as the bias circuit 1B in the above-described Fig. 1. The floating power source circuits 1_1, 1_2 have high-side constant-current sources 1H1, 1H2 and low-side constant-current sources 1L1, 1L2 which are similar to the high- and low-side constant-current sources of the floating power source circuit 1 in Fig. 1, respectively. However, constant-voltage sources 1M1, 1M2 of the floating power source circuits 1_1, 1_2 have a configuration which is somewhat improved as compared with the configuration of the constant-voltage source 1M in Fig. 1.

The constant-voltage sources will be further described in detail. The constant-voltage source 1M1 includes: an NPN transistor 1Mc in which the collector is connected to the high-side constant-current source 1H1, and the emitter is connected to the low-side constant-current source 1L1; a Zener diode 1Md in which the cathode and the anode are connected to the collector and base of the NPN transistor 1Mc, respectively; a resistor 1Me which is connected between the base and emitter of the NPN transistor 1Mc; and a capacitor 1Mf which is connected between the collector and emitter of the NPN transistor 1Mc. The constant-voltage source 1M2 is configured in a manner similar to the constant-voltage source 1M1. The constant-voltage sources 1M1, 1M2 cause a current to flow through the NPN transistor 1Mc, and therefore have an advantage that the allowable loss is larger than that of the constant-voltage source 1M in Fig. 1.

The first stage differential amplifier section 10 has a differential transistor pair having NPN transistors 11, 12. The collectors of the NPN transistors 11, 12 are connected to the high potential source +VB, respectively through resistors 15, 16, and the emitters are commonly connected. A resistor 13 is connected between the common connection node of the emitters and the low potential source -VB. A positive phase input signal HOT is supplied to the base of the NPN transistor 11 through a resistor 41 and a capacitor 42, and a negative phase input signal COLD is supplied to the base of the NPN transistor 12 through a resistor 43 and a capacitor 44. The first stage differential amplifier section 10 differentially amplifies the positive phase input signal HOT and the negative phase input signal COLD, and outputs two-phase differential signals from the collectors of the NPN transistors 11, 12.

The second stage differential amplifier section 20 has a differential transistor pair having PNP transistors 21, 22. The emitters of the PNP transistors 21, 22 are commonly connected, and the common connection node is connected to the high potential source +VB through a resistor 23. The collector of the PNP transistor 21 is connected to the low potential source -VB through a series circuit of resistors 25, 26. The collector of the PNP transistor 22 is connected to the low potential source -VB through a series circuit of resistors 27, 28. The two-phase differential signals output from the collectors of the NPN transistors 11, 12 of the first stage differential amplifier section 10 are supplied to the bases of the PNP transistors 21, 22. The second stage differential amplifier section 20 differentially amplifies the two-phase differential signals, and outputs two-phase differential signals from the collectors of the PNP transistors 21, 22.

In the first output stage NPN transistor 31, the emitter which is the second main electrode is connected to the connection node of the resistors 25, 26, and the base which is the control electrode is connected to the collector of the PNP transistor 21 of the second stage differential amplifier section 20. The collector which is the first main electrode of the first output stage NPN transistor 31 is connected to the negative phase output terminal OUT- of the amplifier 100A.

In the second output stage NPN transistor 32, the emitter which is the second main electrode is connected to the connection node of the resistors 27, 28, and the base which is the control electrode is connected to the collector of the PNP transistor 22 of the second stage differential amplifier section 20. The collector which is the first main electrode of the second output stage NPN transistor 32 is connected to the positive phase output terminal OUT+ of the amplifier 100A.

The emitter of the NPN transistor 1Mc which is the negative electrode of the constant-voltage source 1M1 of the floating power source circuit 1_1 is connected to the emitter which is the second main electrode of the first output stage NPN transistor 31. The collector of the NPN transistor 1Mc which is the positive electrode of the constant-voltage source 1M1 of the floating power source circuit 1_1 is connected to the collector which is the first main electrode of the second output stage NPN transistor 32, and also to the base of the NPN transistor 12 of the first stage differential amplifier section 10 through the resistor 46.

The emitter of the NPN transistor 1Mc which is the negative electrode of the constant-voltage source 1M2 of the floating power source circuit 1_2 is connected to the emitter which is the second main electrode of the second output stage NPN transistor 32. The collector of the NPN transistor 1Mc which is the positive electrode of the constant-voltage source 1M2 of the floating power source circuit 1_2 is connected to the collector which is the first main electrode of the first output stage NPN transistor 31, and also to the base of the NPN transistor 11 of the first stage differential amplifier section 10 through the resistor 45.

The amplifier 100A is configured as described above.

Next, the operation of the amplifier 100A will be described.

In the case where the voltage of the positive phase differential signal HOT is higher than that of the negative phase differential signal COLD, the currents of the NPN transistor 11, the PNP transistor 21, and the first output stage NPN transistor 31 are increased, and those of the NPN transistor 12, the PNP transistor 22, and the second output stage NPN transistor 32 are decreased. Therefore, the push operation from the positive phase output terminal OUT+, and the pull operation to the negative phase output terminal OUT- are performed. Specifically, a current flows through the closed loop of the constant-voltage source 1M1 → the load (not shown) between the positive phase output terminal OUT+ and the negative phase output terminal OUT- → the first output stage NPN transistor 31.

In the case where the voltage of the positive phase differential signal HOT is lower than that of the negative phase differential signal COLD, by contrast, the currents of the NPN transistor 11, the PNP transistor 21, and the first output stage NPN transistor 31 are decreased, and those of the NPN transistor 12, the PNP transistor 22, and the second output stage NPN transistor 32 are increased. Therefore, the pull operation to the positive phase output terminal OUT+, and the push operation from the negative phase output terminal OUT- are performed. Specifically, a current flows through the closed loop of the constant-voltage source 1M2 → the load (not shown) between the negative phase output terminal OUT- and the positive phase output terminal OUT+ → the second output stage NPN transistor 32.

In the amplifier 100A, in this way, the push-pull driving is performed on the first output stage NPN transistor 31 and the second output stage NPN transistor 32 based on the positive phase differential signal HOT and the negative phase differential signal COLD.

During such push-pull driving, then, a negative feedback is performed from the negative phase output terminal OUT- to the base of the NPN transistor 11 of the first stage differential amplifier section 10 through the resistor 45, and a further negative feedback is performed from the positive phase output terminal OUT+ to the base of the NPN transistor 12 of the first stage differential amplifier section 10 through the resistor 46. Therefore, a voltage which is proportional to the difference between the positive phase differential signal HOT and the negative phase differential signal COLD is obtained between the positive phase output terminal OUT+ and the negative phase output terminal OUT-.

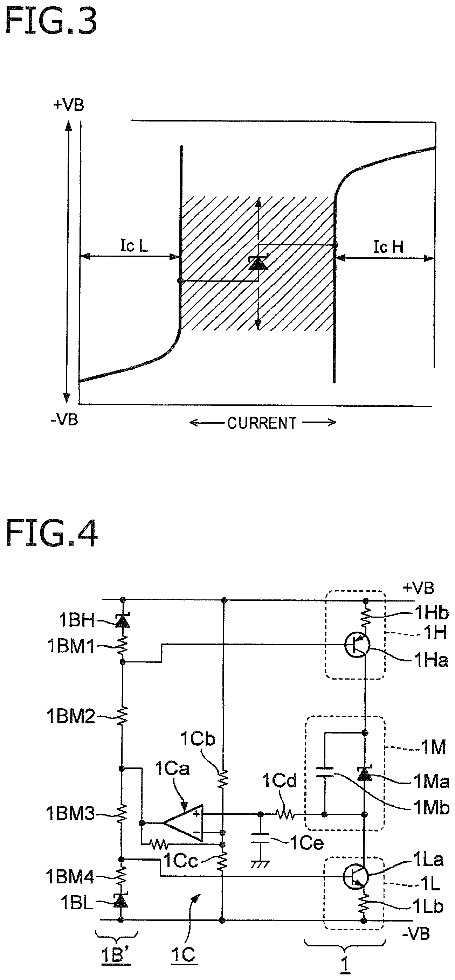

In order to allow such push-pull driving to be performed, the constant-voltage sources 1M1, 1M2 must normally function as a floating power source. Fig. 3 is a view illustrating an operation range of the amplifier 100A where the constant-voltage source 1M1 normally functions as a floating power source. In Fig. 3, the abscissa indicates the current, and the ordinate indicates the voltage of the collector of the PNP transistor 1Ha of the high-side constant-current source 1H1, or that of the collector of the NPN transistor 1La of the low-side constant-current source 1L1. Fig. 3 shows the current value IcH of the high-side constant-current source 1H1, and the current value IcL of the low-side constant-current source 1L1.

When the collector voltage of the NPN transistor 1La is raised from the value of the voltage of the low potential source -VB, as illustrated in Fig. 3, the current value IcL of the low-side constant-current source 1L1 is increased in accordance with the voltage rise. In a region where the collector voltage of the NPN transistor 1La exceeds a voltage which is obtained by subtracting the base-emitter forward voltage of the NPN transistor 1La from the Zener voltage of the Zener diode 1BL, the current value IcL of the low-side constant-current source 1L1 saturates. That is, the low-side constant-current source 1L1 functions as a constant-current source.

When the collector voltage of the PNP transistor 1Ha is lowered from the value of the voltage of the high potential source +VB, by contrast, the current value IcH of the high-side constant-current source 1H1 is increased in accordance with the voltage fall. When the collector voltage of the PNP transistor 1Ha is lowered from the value of the voltage of the high potential source +VB while exceeding a voltage which is obtained by subtracting the base-emitter forward voltage of the PNP transistor 1Ha from the Zener voltage of the Zener diode 1BH, the current value IcH of the high-side constant-current source 1H1 saturates. That is, the high-side constant-current source 1H1 functions as a constant-current source.

In order to allow the constant-voltage source 1M1 to function as a floating power source, the voltage of the collector of the PNP transistor 1Ha, and that of the collector of the NPN transistor 1La must be within the voltage range where the current value IcH of the high-side constant-current source 1H1 saturates, and the current value IcL of the low-side constant-current source 1L1 saturates, i.e., the hatched range in Fig. 3. Although the floating power source circuit 1_1 has been exemplarily described, the description is similarly applicable also to the floating power source circuit 1_2.

In the embodiment, therefore, the circuits (including the load) connected to the positive phase output terminal OUT+ and the negative phase output terminal OUT- take out the output signals from the positive phase output terminal OUT+ and the negative phase output terminal OUT- in a manner that the voltages of the collectors of the PNP transistor 1Ha and NPN transistor 1La of the floating power source circuits 1_1, 1_2 are within the above-described range (the hatched range in Fig. 3).

In order to allow the constant-voltage source 1M1 of the floating power source circuit 1_1 to function as a floating power source, the current value IcH of the high-side constant-current source 1H1, and the current value IcL of the low-side constant-current source 1L1 must coincide with each other. This is applicable also to the constant-voltage source 1M2 of the floating power source circuit 1_2. Even when elements respectively constituting the high-side constant-current source 1H1 and the low-side constant-current source 1L1 have the same characteristics, however, there occurs a subtle difference between the current value IcH of the high-side constant-current source 1H1, and the current value IcL of the low-side constant-current source 1L1. In the embodiment, however, an influence due to the difference between the current value IcH of the high-side constant-current source 1H1, and the current value IcL of the low-side constant-current source 1L1 is mitigated, and the constant-voltage source 1M1 functions as a floating power source. Hereinafter, this will be described.

For example, a case will be considered in which, in a state where no signal is input, and there is no potential difference between the positive phase output terminal OUT+ and the negative phase output terminal OUT-, the current value IcH of the high-side constant-current source 1H1 is larger than the current value IcL of the low-side constant-current source 1L1.

In this state, the positive phase output NPN transistor 32 and the negative phase output NPN transistor 31 are substantially in the OFF state, and no current flows. Therefore, the current of the high-side constant-current source 1H1 flows into the low-side constant-current source 1L1 while passing through the constant-voltage source 1M1. By contrast, the collector currents of the PNP transistors 21, 22 of the second stage differential amplifier section 20 flow into the low potential source -VB, respectively through the resistors 26, 28. At this time, the output potential of the positive phase output terminal OUT+ has a level which is obtained by adding the voltage drop of the resistor 26 and the voltage of the constant-voltage source 1M1 to the potential of the low potential source -VB, and that of the negative phase output terminal OUT- has a level which is obtained by adding the voltage drop of the resistor 28 and the voltage of the constant-voltage source 1M2 to the potential of the low potential source -VB. In the case where the voltages of the constant-voltage sources 1M1, 1M2 are identical to each other, the resistances of the resistors 26, 28 are equal to each other, and, as described above, there is no difference between the output potentials of the positive phase output terminal OUT+ and the negative phase output terminal OUT-, currents flow evenly through the resistors 26, 28.

In the case where, as described above, the current value IcH of the high-side constant-current source 1H1 is larger than the current value IcL of the low-side constant-current source 1L1, with respect to the current of the differential current value ΔI = IcH - IcL between the currents, however, there is no flow path but the resistor 26. Therefore, a larger current flows through the resistor 26, and the above-described state where currents flow evenly through the resistors 26, 28 is not attained, and, in accordance with this, the potential of the positive phase output terminal OUT+ is shifted in the positive direction. In the system of the whole circuit, here, the variation of the output potential is returned to the first stage differential amplifier section 10 by the feedbacks due to the resistors 45, 46, and the current is again supplied to the second stage differential amplifier section 20. This functions so that the collector current of the PNP transistor 21 is decreased, the current of the PNP transistor 22 is increased, currents flow evenly through the resistors 26, 28, and therefore the difference between the output potentials of the positive phase output terminal OUT+ and the negative phase output terminal OUT- is eliminated.

Even in the case where there is a difference between the current value IcH of the high-side constant-current source 1H1 and the current value IcL of the low-side constant-current source 1L1, as described above, the difference is absorbed by the feedback operation of the amplifier, and the constant-voltage source 1M1 continues to function as a floating power source.

In the above, the description has been made by exemplifying the case where the current value IcH of the high-side constant-current source 1H1 is larger than the current value IcL of the low-side constant-current source 1L1. Even in the case where the voltage level relationship is reversed, the difference between the current values is eliminated by a similar feedback operation, and the constant-voltage source 1M1 functions as a floating power source. Although, in the above description, the floating power source circuit 1_1 has been exemplified, a similar description is applicable to the floating power source circuit 1_2.

In the embodiment, as described above, the floating power source circuits 1_1, 1_2 can be configured without using an insulating unit such as a transformer, and therefore the amplifier 100A can be economically realized.

### <Other embodiments>

Although the reference example and first embodiment of the invention have been described, other embodiments of the invention are possible. For example, the following embodiments may be considered.
(1) A function of controlling the reference potential of the output voltage may be provided to the floating power source circuit of the invention, and this configuration may be used as a power source which fixes the potential in a DC manner.

Fig. 4 shows a configuration example in which a function of controlling the reference potential of the output voltage is provided to the floating power source circuit 1 (see Fig. 1) of the reference example. In the configuration example, the bias circuit 1B in Fig. 1 which is described above is replaced with a bias circuit 1B' in which four resistors 1BM1 to 1BM4 are connected in series between the Zener diodes 1BH, 1BL. In the configuration example, moreover, the connection node of the resistors 1BM1, 1BM2 is connected to the base of the PNP transistor 1Ha, and that of the resistors 1BM3, 1BM4 is connected to the base of the NPN transistor 1La. In the configuration example, furthermore, a reference potential controller 1C is disposed. The reference potential controller 1C has an error amplifier 1Ca, resistors 1Cb, 1Cc, and an integrating circuit formed by a resistor 1Cd and a capacitor 1Ce. Here, the resistors 1Cb, 1Cc are connected in series between the high potential source +VB and the low potential source -VB, and function as a voltage dividing circuit which outputs a comparison voltage. The error amplifier 1Ca amplifies an error between a voltage which is obtained by integrating the collector voltage of the NPN transistor 1La by the integrating circuit formed by the resistor 1Cd and the capacitor 1Ce, and the comparison voltage that is generated at the connection node of the resistors 1Cb, 1Cc. Based on a result of the above, the potential of the connection node of the resistors 1BM2, 1BM3 is controlled.

According to the configuration, when the collector voltage of the NPN transistor 1La is higher than the comparison voltage, the error amplifier 1Ca raises the potential of the connection node of the resistors 1BM2, 1BM3. This causes the value of the collector current of the PNP transistor 1Ha to be relatively lowered with respect to the current value of the NPN transistor 1La, and the collector voltage of the NPN transistor 1La is lowered.

When the collector voltage of the NPN transistor 1La is lower than the comparison voltage, by contrast, the error amplifier 1Ca lowers the potential of the connection node of the resistors 1BM2, 1BM3. This causes the value of the collector current of the PNP transistor 1Ha to be relatively raised with respect to the current value of the NPN transistor 1La, and the collector voltage of the NPN transistor 1La is raised.

As a result of this feedback control, the collector voltage of the NPN transistor 1La coincides with the comparison voltage.
(2) In the modification of Fig. 4, a configuration may be employed where the division ratio of the voltage dividing circuit configured by the resistors 1Cb, 1Cc can adjusted by operating, for example, an operator.
(3) In the reference example and first embodiment, the floating power source circuit and the amplifier are configured by bipolar transistors. Alternatively, the floating power source circuit and the amplifier may be configured by FETs such as J-FETs (Junction Field Effect transistors) or MOSFETs (Metal Oxide Semiconductor Field Effect transistors).
(4) Although, in the first embodiment, the invention is applied to an amplifier using two floating power sources, the range of application of the invention is not limited to this. The invention can be applied also to an amplifier using three or more floating power sources. Moreover, the range of application of the floating power source of the invention is not limited to an amplifier. The floating power source of the invention can be applied also to a use other than an amplifier.

### REFERENCE SIGNS LIST

1, ... floating power source circuit
1B, 1B' ... bias circuit
1H ... high-side constant-current source
1L ... low-side constant-current source
1M, 1M' ... constant-voltage source
1Ha, 21, 22, ... PNP transistor
1La, 11, 12 ... NPN transistor
1BH, 1BL, 1Ma, 1Md ... Zener diode
1BM, 1BM1, 1BM2, 1BM3, 1BM4, 1Hb, 1Lb, 41, 43, 45, 46, 13, 15, 16, 23, 25,
26, 27, 28, 1Cb, 1Cc, 1Cd ... resistor
1C ... reference potential controller
1Ca ... error amplifier
1Mb, 42, 44
1Ce ... capacitor

## Claims

1. An amplifier (100A) comprising:
first (31) and second (32) transistors each of which has first and second main electrodes, and a control electrode to which a control signal for controlling a conduction state between the first and second main electrodes is supplied, the control signals being supplied respectively to the control electrodes for push-pull driving the first and second transistors;
a first constant-voltage source (1M1) which is connected between the second main electrode of the first transistor (31) and the first main electrode of the second transistor (32);
a second constant-voltage source (1M2) which is connected between the second main electrode of the second transistor (32) and the first main electrode of the first transistor (31);
**characterized by**:
a first high-side constant-current source (1H1) which is connected between a high potential source and a connection node which connects the first main electrode of the second transistor and the first constant-voltage source (1M1);
a first low-side constant-current source (1L1) which is connected between a low potential source and a connection node which connects the second main electrode of the first transistor and the first constant-voltage source (1M1);
a second high-side constant-current source (1H2) which is connected between the high potential source and a connection node which connects the first main electrode of the first transistor and the second constant-voltage source (1M2); and
a second low-side constant-current source (1L2) which is connected between the low potential source and a connection node which connects the second main electrode of the second transistor and the second constant-voltage source (1M2); wherein
the push-pull driving of the first and second transistors is performed by differentially amplifying two-phase input signals,
the amplifier (100A) further comprising:
a feedback circuit (45,46) which negatively feedbacks voltages of the first main electrodes of the first and second transistors to a unit for differentially amplifying the two-phase input signals.

## Patentansprüche

1. Verstärker (100A) umfassend:
erste (31) und zweite (32) Transistoren, von denen jeder erste und zweite Hauptelektroden und eine Steuerelektrode aufweist, an welche ein Steuersignal zum Regeln eines Leitzustands zwischen den ersten und zweiten Hauptelektroden angelegt wird, wobei die Steuersignale jeweils an die Steuerelektroden zur Gegentaktansteuerung der ersten und zweiten Transistoren angelegt werden;
eine erste Konstantspannungsquelle (1M1), die zwischen der zweiten Hauptelektrode des ersten Transistors (31) und der ersten Hauptelektrode des zweiten Transistors (32) geschaltet ist;
eine zweite Konstantspannungsquelle (1M2), die zwischen der zweiten Hauptelektrode des zweiten Transistors (32) und der ersten Hauptelektrode des ersten Transistors (31) geschaltet ist;
**gekennzeichnet durch**:
eine erste High-Side-Konstantstromquelle (1H1), die zwischen einer Hochpotentialquelle und einem Verbindungsknoten geschaltet ist, der die erste Hauptelektrode des zweiten Transistors und die erste Konstantspannungsquelle (1M1) miteinander verbindet;
eine erste Low-Side-Konstantstromquelle (1L1), die zwischen einer Niedrigpotentialquelle und einem Verbindungsknoten geschaltet ist, der die zweite Hauptelektrode des ersten Transistors und die erste Konstantspannungsquelle (1M1) miteinander verbindet;
eine zweite High-Side-Konstantstromquelle (1H2), die zwischen der Hochpotentialquelle und einem Verbindungsknoten geschaltet ist, der die erste Hauptelektrode des ersten Transistors und die zweite Konstantspannungsquelle (1M2) miteinander verbindet; und
eine zweite Low-Side-Konstantstromquelle (1L2), die zwischen der Niedrigpotentialquelle und einem Verbindungsknoten geschaltet ist, der die zweite Hauptelektrode des zweiten Transistors und die zweite Konstantspannungsquelle (1M2) miteinander verbindet; wobei
die Gegentaktansteuerung der ersten und zweiten Transistoren wird durchgeführt, indem die zweiphasigen Eingangssignale differenziell verstärkt werden,
der Verstärker (100A) weiter umfassend:
eine Rückkopplungsschaltung (45,46), die die Spannungen der ersten Hauptelektroden der ersten und zweiten Transistoren negativ rückkoppelt auf eine Einheit, die die zweiphasigen Eingangssignale differenziell verstärkt.

## Revendications

1. Amplificateur (100A) comprenant :
un premier (31) et un second (32) transistors, chacun d'eux présentant une première et une seconde électrodes principales, et une électrode de commande à laquelle est fourni un signal de commande pour commander un état de conduction entre les première et seconde électrodes principales, les signaux de commande étant fournis respectivement aux électrodes de commande pour une commande en push-pull des premier et second transistors ;
une première source de tension constante (1M1) qui est connectée entre la seconde électrode principale du premier transistor (31) et la première électrode principale du second transistor (32) ;
une seconde source de tension constante (1M2) qui est connectée entre la seconde électrode principale du second transistor (32) et la première électrode principale du premier transistor (31) ;
**caractérisé par** :
une première source de courant constante côté haut (1H1) qui est connectée entre une source de potentiel élevé et un nœud de connexion qui connecte la première électrode principale du second transistor et la première source de tension constante (1M1) ;
une première source de courant constante côté bas (1L1) qui est connectée entre une source de potentiel faible et un nœud de connexion qui connecte la seconde électrode principale du premier transistor et la première source de tension constante (1M1) ;
une seconde source de courant constante côté haut (1H2) qui est connectée entre la source de potentiel élevé et un nœud de connexion qui connecte la première électrode principale du premier transistor et la seconde source de tension constante (1M2) ; et
une seconde source de courant constante côté bas (1L2) qui est connectée entre la source de potentiel faible et un nœud de connexion qui connecte la seconde électrode principale du second transistor et la seconde source de tension constante (1M2) ; dans lequel
la commande en push-pull du premier et du second transistors est réalisée en amplifiant de manière différentielle deux signaux d'entrée en opposition de phase,
l'amplificateur (100A) comprenant en outre :
un circuit de contre-réaction (45,46) qui applique en contre-réaction négative des tensions des premières électrodes principales des premier et second transistors à une unité pour amplifier de manière différentielle les deux signaux d'entrée en opposition de phase.
